# EUROPEAN PATENT APPLICATION

(11) **EP 4 565 021 A1**
(43) Date of publication of application: **04.06.2025**
(21) Application number: 24839846.3
(22) Date of filing: 19.03.2024
(51) Int. Cl.: H05K 7/20, B32B 37/06, B32B 9/00

(54) **METHOD FOR MANUFACTURING GRAPHITE HEAT DISSIPATION SHEET**

(30) Priority: 07.07.2023 KR 20230088215
(71) Applicant: HTC Co., Ltd, Ansan-si Gyeonggi-do 15421 (KR)
(72) Inventor: KWON, Jae Sung, Yongin-si Gyeonggi-do 17003 (KR); PARK, Sang Ku, Siheung-si Gyeonggi-do 14963 (KR); KIM, Byung Soo, Incheon 22535 (KR); LEE, Ho, Ansan-si Gyeonggi-do 15289 (KR)
(74) Representative: Cabinet Chaillot
(86) International application number: PCT/KR2024/003394
(87) International publication number: WO 2025/014025

(57) **Abstract**

Proposed is a manufacturing method of a graphite heat dissipation sheet. The manufacturing method includes a first process in which a graphite sheet (110) having a predetermined width is disposed between a pair of protective films (120) having inner side surfaces provided with thermal fusion layers (121) and both side surfaces of the protective films (120) are thermally fused so that both side surfaces of the graphite sheet (110) are sealed, a second process in which an inner portion of the graphite sheet (110) is vacuum-evacuated, opening parts of the protective films (120) are thermally fused so that the graphite sheet (110) is entirely sealed, and then heat is applied to surfaces of the protective films (120) such that the surfaces of the protective films (120) are thermally fused with the graphite sheet (110), and a third process in which a border part of the graphite sheet (110) is cut.

## Description

### Technical Field

The present disclosure relates to a manufacturing method of a graphite heat dissipation sheet. More particularly, the present disclosure relates to a manufacturing method of a graphite heat dissipation sheet, in which a graphite sheet is covered with a film or a pouch having an inner side surface provided with a thermal fusion layer and an inner portion of the graphite sheet is vacuum-evacuated so that a gas and moisture remaining inside the graphite sheet are removed, heat is applied to the thermal fusion layer so that a fusion effect between the graphite sheet and a surface of the film or between the graphite sheet and a surface of the pouch is realized, and that a pressing effect due to a pressure difference by vacuum is added, thereby being capable of manufacturing the graphite heat dissipation sheet in which the film and the graphite sheet or the pouch and the graphite sheet are more solidly integrated with each other.

### Background Art

Recently, as electronic devices have been highly integrated and become thinner at a rapid pace, the performance of chips and so on mounted in such devices has been reinforced. This trend is spreading to not only electric/electronic devices but also automobiles, medical devices, and so on. As the chips used in electronic devices are highly integrated, more heat is generated, thereby causing many problems such as deterioration in the performance of the electronic devices, malfunction of their peripheral devices, thermal degradation of their substrates, and so on.

Particularly, a thinner heat dissipation material is required for an electronic device (a TV and so on) that employs an LED, an OLED, or the like. In this regard, a substrate on which an IC chip is mounted is made of a metal printed circuit board (PCB) having good thermal conductivity, or a heat sink made of aluminum is used to thereby control heat. In addition, a thermally conductive thin film such as a natural graphite thin film and a synthetic graphite thin film that employs a carbon-based material, a copper plate, and so on are mainly used for controlling heat in electronic devices and so on.

Meanwhile, in a heat dissipation sheet that employs natural graphite and/or synthetic graphite is capable of being configured as a thin film, has excellent heat dissipation performance, and is capable of being attached to and used in a heat generation region of an electronic device (a TV and so on), so that extensive research on such a heat dissipation sheet has been conducted.

Such a graphite heat dissipation sheet described above is generally manufactured in a sheet shape by rolling foamed graphite particles, and there is a disadvantage that dusts are generated and has high brittleness. In order to compensate for such structural disadvantages and to attach the graphite heat dissipation sheet to a subject of application, as mentioned in Korean Patent No. 10-1509494, the graphite heat dissipation sheet may be laminated with a protective film and then an adhesive layer and a release film for protecting the adhesive layer may be separately provided. At this time, the protective film and the graphite sheet are bonded with a hot melt, an acrylic adhesive, and so on that are applied between the protective film and the graphite sheet.

Meanwhile, since the graphite sheet has a layered structure due to rolling manufacturing, residual gas and moisture exist inside the graphite sheet, which causes the generation of bubbles after laminating. In addition, during laminating, when foreign substances are present on a surface of the graphite sheet, air bubbles may occur, and there is a disadvantage that the protective films may be delaminated since the adhesive force between the protective films in a border part is weak.

### Disclosure

### Technical Problem

Accordingly, the present disclosure has been made keeping in mind the above problems occurring in the related art, and an objective of the present disclosure is to provide a manufacturing method of a graphite heat dissipation sheet, the manufacturing method being configured such that a graphite sheet is covered with a film or a pouch having an inner side surface provided with a thermal fusion layer and an inner portion of the graphite sheet is vacuum-evacuated so that a gas and moisture remaining inside the graphite sheet are removed, heat is applied to the thermal fusion layer so that a fusion effect between the graphite sheet and a surface of the film or between the graphite sheet and a surface of the pouch is realized, and that a pressing effect due to a pressure difference by vacuum is added, thereby being capable of manufacturing the graphite heat dissipation sheet in which the film and the graphite sheet or the pouch and the graphite sheet are more solidly integrated with each other.

### Technical Solution

In order to achieve the objective described above, according to the present disclosure, there is provided a manufacturing method of a graphite heat dissipation sheet, the manufacturing method including: a first process in which a graphite sheet having a predetermined width is disposed between a pair of films having inner side surfaces provided with thermal fusion layers that have a thermoplastic characteristic that causes the thermal fusion layers to melt at a predetermined temperature and in which both side surfaces of the pair of films are thermally fused, thereby sealing both side surfaces of the graphite sheet; a second process in which an inner portion of the graphite sheet having both sealed side surfaces thereof is vacuum-evacuated, opening parts of the pair of films are thermally fused so that the graphite sheet is entirely sealed, and then heat is applied to surfaces of the pair of films such that the thermal fusion layers are melted so that the graphite sheet and the surfaces of the pair of films are thermally fused; and a third process in which a border part of the graphite sheet is cut.

The fist process may include a process in which both side surfaces of the pair of films are thermally fused so that both side surfaces of the graphite sheet are sealed when the pair of films are continuously supplied from a film supply mechanism and the graphite sheet is input between the pair of films, and may include a process in which the pair of films is cut to a length capable of sufficiently covering the graphite sheet.

In the second process, it is preferable that the vacuum-evacuation, the thermal fusion of the opening parts, and the thermal fusion of the surfaces of the pair of films are performed simultaneously in a vacuum chamber by inputting the graphite sheet having both sealed side surfaces in the vacuum chamber and depressurizing the graphite sheet under vacuum for a predetermined time and then pressing the graphite sheet with a vertical heating member.

Meanwhile, the second process may include a process in which the graphite sheet having both sealed side surfaces is input in a vacuum chamber and is depressurized under vacuum for a predetermined time and then is heated and pressed so that the vacuum-evacuation is performed and the opening parts are thermally fused, and may include a process in which the graphite sheet is input in a high-temperature chamber and is heated so that the surfaces of the pair of films and the graphite sheet are thermally fused with each other.

In addition, in order to achieve the objective described above, according to the present disclosure, there is provided a manufacturing method of a graphite heat dissipation sheet, the manufacturing method including: a first process in which a graphite sheet having a predetermined width is inserted into and disposed inside a film-type pouch which has an inner side surface provided with a thermal fusion layer with a thermoplastic characteristic that causes the thermal fusion layer to melt at a predetermined temperature and which has a first side open; a second process in which an inner portion of the graphite sheet is vacuum-evacuated by applying vacuum to the film-type pouch having the first side open, thermally fusing an opening part of the film-type pouch so that the graphite sheet is entirely sealed, and applying heat to a surface of the film-type pouch such that the thermal fusion layer is melt so that the graphite sheet and the surface of the film-type pouch are thermally fused with each other; and a third process in which a border part of the graphite sheet is cut.

In the second process, it is preferable that the vacuum-evacuation, the thermal fusion of the opening part, and the thermal fusion of the surface of the film-type pouch are performed simultaneously in a vacuum chamber by inputting the film-type pouch having the graphite sheet disposed in an inner portion of the film-type pouch in the vacuum chamber and depressurizing the film-type pouch under vacuum for a predetermined time and then pressing the film-type pouch with a vertical heating member.

Meanwhile, the second process may include a process in which the film-type pouch having the graphite sheet disposed in an inner portion of the film-type pouch is input in a vacuum chamber and is depressurized under vacuum for a predetermined time and then is heated and pressed so that the vacuum-evacuation is performed and the opening part is thermally fused, and may include a process in which the film-type pouch is input in a high-temperature chamber and is heated so that the surface of the film-type pouch and the graphite sheet are thermally fused with each other.

### Advantageous Effects

In the manufacturing method of the graphite heat dissipation sheet of the present disclosure, the graphite sheet is covered with the film or the pouch that are having the inner side surface thereof provided with the thermal fusion layer, the inner portion of the graphite sheet is vacuum-evacuated so that a gas and moisture remaining inside the graphite sheet are removed, heat is applied to the thermal fusion layer so that the fusion effect between the graphite sheet and the film or between the graphite sheet and the surface of the pouch is realized, and the pressing effect due to the pressure difference by vacuum is added, so that there is an advantage that the graphite heat dissipation sheet in which the film and the graphite sheet or the pouch and the graphite sheet are more solidly integrated with each other is capable of being manufactured.

### Description of Drawings

FIG. 1 is a schematic view illustrating a manufacturing method of a graphite heat dissipation sheet according to an embodiment of the present disclosure,
FIG. 2 is a cross-sectional view illustrating a configuration relationship of the graphite heat dissipation sheet manufactured by the manufacturing method illustrated in FIG. 1, and
FIG. 3 is a schematic view illustrating the manufacturing method of the graphite heat dissipation sheet according to another embodiment of the present disclosure.

### Mode for Invention

Hereinafter, an exemplary embodiment of a manufacturing method of a graphite heat dissipation sheet according to the present disclosure will be described in detail with reference to the accompanying drawings. The present disclosure is not limited to the embodiments disclosed below, but may be implemented in various different forms. The present embodiments are provided so that the present disclosure will be thorough and complete, and will fully convey the scope of the present disclosure to those skilled in the art.

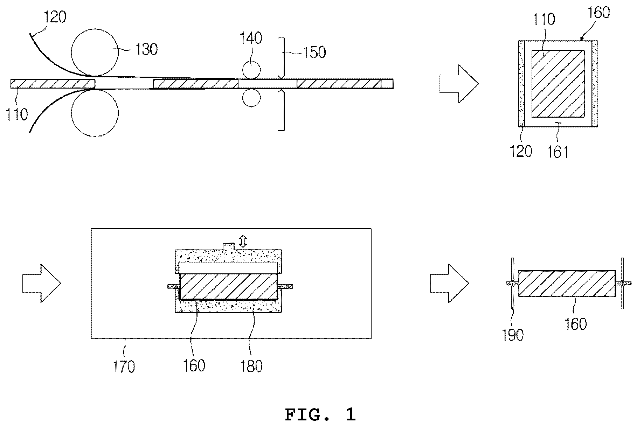

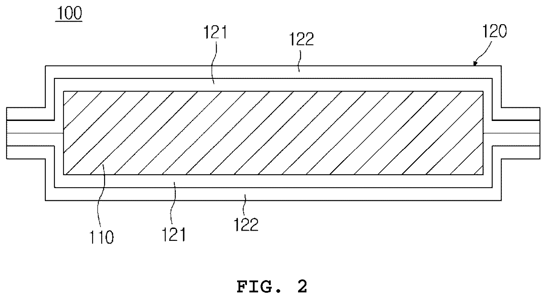

FIG. 1 is a schematic view illustrating the manufacturing method of the graphite heat dissipation sheet according to an embodiment of the present disclosure, and FIG. 2 is a cross-sectional view illustrating a configuration relationship of the graphite heat dissipation sheet manufactured by the manufacturing method illustrated in FIG. 1.

As illustrated in FIG. 1 and FIG. 2, the manufacturing method of the graphite heat dissipation sheet of the embodiment includes: a first process in which a graphite sheet 110 having a predetermined breadth is disposed between a pair of protective films 120 having inner side surfaces provided with thermal fusion layers 121 and both side surfaces of the pair of protective films 120 are thermally fused so that both side surfaces of the graphite sheet 110 are sealed; a second process in which an inner portion of the graphite sheet 110 having both sealed side surfaces thereof is vacuum-evacuated, opening parts of the pair of protective films 120 are thermally fused so that the graphite sheet 110 is entirely sealed, and then heat is applied to surfaces of the pair of protective films 120 such that the surfaces of the pair of protective films 120 are thermally fused with the graphite sheet 110; and a third process in which a border part of the graphite sheet 110 is cut.

In the first process, the pair of protective films 120 is continuously supplied from a film supply roll 130 that constitutes a film supply mechanism. Furthermore, the first process may include a process in which both side surfaces of the pair of protective films 120 are thermally fused so that both side surfaces of the graphite sheet 110 are sealed and a process in which the pair of protective films 120 is cut to a length capable of sufficiently covering the graphite sheet 110 when the graphite sheet 110 is input between the pair of protective films 120.

The graphite sheet 110 is formed by pressing or rolling graphite powder to a predetermined thickness and a predetermined such that the graphite sheet 110 has a predetermined breadth, and natural graphite, artificial graphite, or a mixture thereof may be used for forming the graphite sheet 110. For example, the graphite sheet 110 of the embodiment may be formed by mixing 80 wt% to 95 wt% of natural graphite and 5 wt% to 20 wt% of artificial graphite 5 to 20% by weight. Here, natural graphite is foamed graphite, and foamed graphite is obtained by pulverizing natural graphite into powder and then performing sulfuric acid immersion, neutralization washing, and heating at high-temperature for foaming. As natural graphite of the embodiment, a mixture in which foamed graphite having a diameter of 30 *µ*m to 50 *µ*m and foamed graphite having a diameter of 200 *µ*m to 250 *µ*m are mixed with each other with a predetermined ratio may be used. Furthermore, as artificial graphite, artificial graphite having a diameter of 20 *µ*m to 80 *µ*m may be used.

That is, the graphite sheet 110 of the embodiment may be formed of natural graphite and/or artificial graphite having the characteristics (the diameter and the composition ratio) as described above, but it is not necessary to limit the graphite sheet 110 to graphite having the limited characteristics described above. In addition, the graphite sheet 110 of the embodiment may be pressed such that the graphite sheet 110 has a density of 0.8 g/cm³ to 1.65 g/cm³, but there is no limitation.

The graphite sheet 110 as described above contains fine amounts of gas within graphite, and has a porous structure so that pores are formed in the graphite sheet 110 even when the graphite sheet 110 is pressed or rolled such that the graphite sheet 110 has the predetermined density. Furthermore, a gas such as sulfuric acid gas generated during the manufacturing process of the graphite sheet 110 and moisture in the atmosphere are inevitably contained in the pores.

The protective film 120 is formed of the thermal fusion layer 121 forming the inner side surface of the protective film 120, and is formed of a protective layer 122 forming an outer side surface of the protective film 120. Here, the thermal fusion layer 121 may be formed of a material having a thermoplastic characteristic melting at a predetermined temperature, such as polyethylene (PE), cast polypropylene (CPP), low-density polyethylene (LDPE), linear low-density polyethylene (LLDPE), high-density polyethylene (HDPE), and so on. Meanwhile, it is preferable that a thickness of the thermal fusion layer 121 is less than 50 *µ*m in order to minimize an effect on the thermal diffusion performance. The protective layer 122 serves to protect the graphite sheet 110 that will be positioned inside the protective layer 122, and may be formed of polyethylene terephthalate (PET), nylon (Ny), ethylene vinyl alcohol (EVOH), or the like. Here, it is preferable that a thickness of the protective layer 122 is less than 20 *µ*m in order to minimize an effect on the thermal diffusion performance.

In performing the first process by using the graphite sheet 110 and the pair of protective films 120 as described above, the pair of protective films 120 is continuously supplied by using a pair of film supply rolls 130. Here, the film supply mechanism and the pair of film supply rolls 130 are configured on the basis of a configuration relationship generally used in the industry, and the pair of protective films 120 may be continuously supplied in a general manner. At this time, the pair of film supply rolls 130 is configured to supply the pair of protective films 120 in a state in which the pair of film supply rolls 130 is disposed to be vertically spaced apart from each other in a predetermined distance and, accordingly, a space into which the graphite sheet 110 is capable of being input is formed between the pair of protective films 120.

Therefore, the graphite sheet 110 is input into the space formed between the pair of protective films 120 supplied, is disposed between the pair of protective films 120, and is in a state in which the graphite sheet 110 is in close contact with the pair of protective films 120 by the pair of film supply rolls 130 and a pair of guide rolls 140 positioned in rear of the pair of film supply rolls 130. In such a graphite sheet 110, both side surfaces of the graphite sheet 110 are sealed by thermally fusing both side surfaces of the pair of protective films 120 between the pair of film supply rolls 130 and the pair of guide rolls 140. At this time, the thermal fusion of both side surfaces of the pair of protective films 120 is performed by heating the thermal fusion layers 121 forming the inner side surfaces of the pair of protective films 120 and bonding the thermal fusion layers 21, and may be performed by using a heating member (not illustrated) having a predetermined width. Then, as the pair of protective films 120 is cut to a length capable of sufficiently covering the graphite sheet 110 by using a cutting member 150 positioned in rear of the pair of guide rolls 140, a graphite heat dissipation member 160 having both side surfaces sealed by the pair of protective films 120 and having opening parts 161 at front and rear sides thereof or at upper and lower portions thereof is formed.

The second process is a process in which the graphite sheet 110 is entirely sealed and the surfaces between the pair of protective films 120 and the graphite sheet 110 are thermally fused. In the second process, a process in which the graphite heat dissipation member 160 is input into a vacuum chamber 170 and the graphite heat dissipation member 160 is depressurized under vacuum for a predetermined time and then is pressed by a vertical heating member 180 so that an inner portion of the graphite heat dissipation member 160 is vacuum-evacuated, a process in which the opening parts 161 of the graphite heat dissipation member 160 are bonded to each other by thermal fusion, and a process in which the surfaces between the pair of protective films 120 and the graphite sheet 110 are thermally fused are performed simultaneously in the vacuum chamber 170.

Here, the vacuum chamber 170 is a vacuum chamber generally used in the industry, and the vacuum chamber 170 is configured such that the vacuum chamber 170 vacuum-evacuates the inner portion of the graphite heat dissipation member 160 and the vacuum chamber 170 has a vacuum pressure capable of vacuum-evacuating and removing a gas and moisture remaining inside the graphite sheet 110. In addition, the vertical heating member 180 is configured as a hot press machine having a mold shape surrounding upper and lower surfaces and a border of the graphite heat dissipation member 160, and is configured to bonding the opening parts 161 of the opening parts of the graphite heat dissipation sheet 160 by thermal fusion and is configured to integrate the surfaces between the pair of protective films 120 and the graphite sheet 110 by thermal fusion. As such, in the second process, heat is applied to the thermal fusion layers 121 formed on the inner side surfaces of the protective films 120 so that an effect in which the surfaces between the graphite sheet 110 and the pair of protective films 120 are fused in a molten state is realized, and a pressing effect by a pressure difference due to vacuum is added, so that the pair of protective films 120 and the graphite sheet 110 are more solidly integrated with each other.

Meanwhile, in the second process, after the process in which the graphite heat dissipation member 160 is input into the vacuum chamber 170 described above and the graphite heat dissipation member 160 is depressurized under vacuum for the predetermined time and then is heated and pressed so that the inner portion of the graphite heat dissipation member 160 is vacuum-evacuated, and the process in which the opening parts 161 of the graphite heat dissipation member 160 are bonded by thermal fusion is performed first, a process in which the graphite heat dissipation member 160 is input in a high-temperature chamber having a temperature at least 110 degrees Celsius and is heated such that the surfaces between the pair of protective films 120 and the graphite sheet 110 are thermally fused may be performed. Here, the thermal fusion of the opening parts 161 of the graphite heat dissipation member 160 is performed by heating the thermal fusion layers 121 forming the inner side surfaces of the pair of protective films 120 and bonding the thermal fusion layers 21, and may be performed by using a heating member (not illustrated) having a predetermined width.

The third process is a process of completing a graphite heat dissipation sheet 100 by cutting an unnecessary part of a border part of the graphite heat dissipation member 160 by using a cutting mechanism 190. Here, the cutting mechanism 190 is configured on the basis of a configuration relationship generally used in the industry, and is configured to cut and remove an unnecessary part of the border part of the graphite heat dissipation member 160. At this time, it is preferable that the border part of the final graphite heat dissipation sheet 100 is cut such that the border part of the final graphite heat dissipation sheet has a minimum bezel.

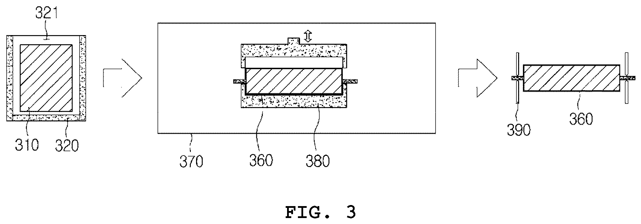

FIG. 3 is a schematic view illustrating the manufacturing method of the graphite heat dissipation sheet according to another embodiment of the present disclosure. As illustrated in FIG. 3, the manufacturing method of the graphite heat dissipation sheet according to another embodiment includes: a first process in which a graphite sheet 310 having a predetermined breadth is inserted into and disposed inside a film-type pouch (bag) 320 having an inner side surface provided with a thermal fusion layer and having a first side open; a second process in which an inner portion of the graphite sheet 310 is vacuum-evacuated by applying vacuum to the film-type pouch 320 having the first side open, the graphite sheet 310 is entirely sealed by thermally fusing an opening part 321 of the film-type pouch 320, and then heat is applied to a surface of the film-type pouch 320 so that the surface of the film-type pouch 320 and a surface of the graphite sheet 310 are thermally fused with each other; and a third process in which a border part of the graphite sheet 310 is cut. In the film-type pouch 320 of this embodiment, it is preferable that three surfaces of a film of the film-type pouch 320 are sealed by thermal fusion.

Except that the manufacturing method of the graphite heat dissipation sheet in this embodiment has the film-type pouch (bag) 320 having the inner side surface provided with the thermal fusion layer and having the first side open, the final graphite heat dissipation sheet is formed by performing the first process, the second process, and the third process that are similar to the manufacturing method illustrated in FIG. 1, so that the description thereof will be omitted. In FIG. 3, the reference numeral 360 refers to a graphite heat dissipation member, the reference numeral 370 refers to a vacuum chamber, the reference numeral 380 refers to a vertical heating member, and the reference numeral 390 refers to a cutting mechanism.

In the manufacturing method of the graphite heat dissipation sheet of the present disclosure, the graphite sheet is covered with the protective film or the pouch having the inner side surface provided with the thermal fusion layer, the inner portion of the graphite sheet is vacuum-evacuated so that a gas and moisture remaining inside the graphite sheet are removed, heat is applied to the thermal fusion layer so that the fusion effect between the graphite sheet and the protective film or between the graphite sheet and the surface of the pouch is realized, and the pressing effect due to the pressure difference by vacuum is added, so that the graphite heat dissipation sheet in which the protective film and the graphite sheet or the pouch and the graphite sheet are more solidly integrated with each other is capable of being manufactured.

The features of the manufacturing method of the graphite heat dissipation sheet of the present disclosure have been described above with reference to the accompanying drawings, but they are just preferable examples. Therefore, it is apparent to those skilled in the art that the present disclosure is not limited to the embodiments and may be modified in various ways without departing from the spirit and scope of the present disclosure, so it should be understood that those modifications and changes are included in claims of the present disclosure.

### Industrial Applicability

The graphite heat dissipation sheet of the present disclosure is capable of being configured as a thin film, has excellent heat dissipation performance, and is capable of being conveniently attached to and used at a heat generation area of an electronic device (a TV and so on).

## Claims

1. A manufacturing method of a graphite heat dissipation sheet, the manufacturing method comprising:
a first process in which a graphite sheet having a predetermined width is disposed between a pair of films having inner side surfaces provided with thermal fusion layers that have a thermoplastic characteristic that causes the thermal fusion layers to melt at a predetermined temperature and in which both side surfaces of the pair of films are thermally fused, thereby sealing both side surfaces of the graphite sheet;
a second process in which an inner portion of the graphite sheet having both sealed side surfaces thereof is vacuum-evacuated, opening parts of the pair of films are thermally fused so that the graphite sheet is entirely sealed, and then heat is applied to surfaces of the pair of films such that the thermal fusion layers are melted so that the graphite sheet and the surfaces of the pair of films are thermally fused; and
a third process in which a border part of the graphite sheet is cut.

2. The manufacturing method of claim 1, wherein the fist process comprises a process in which both side surfaces of the pair of films are thermally fused so that both side surfaces of the graphite sheet are sealed when the pair of films are continuously supplied from a film supply mechanism and the graphite sheet is input between the pair of films, and comprises a process in which the pair of films is cut to a length capable of sufficiently covering the graphite sheet.

3. The manufacturing method of claim 1 or claim 2, wherein, in the second process, the vacuum-evacuation, the thermal fusion of the opening parts, and the thermal fusion of the surfaces of the pair of films are performed simultaneously in a vacuum chamber by inputting the graphite sheet having both sealed side surfaces in the vacuum chamber and depressurizing the graphite sheet under vacuum for a predetermined time and then pressing the graphite sheet with a vertical heating member.

4. The manufacturing method of claim 1 or claim 2, wherein the second process comprises a process in which the graphite sheet having both sealed side surfaces is input in a vacuum chamber and is depressurized under vacuum for a predetermined time and then is heated and pressed so that the vacuum-evacuation is performed and the opening parts are thermally fused, and comprises a process in which the graphite sheet is input in a high-temperature chamber and is heated so that the surfaces of the pair of films and the graphite sheet are thermally fused with each other.

5. A manufacturing method of a graphite heat dissipation sheet, the manufacturing method comprising:
a first process in which a graphite sheet having a predetermined width is inserted into and disposed inside a film-type pouch which has an inner side surface provided with a thermal fusion layer with a thermoplastic characteristic that causes the thermal fusion layer to melt at a predetermined temperature and which has a first side open;
a second process in which an inner portion of the graphite sheet is vacuum-evacuated by applying vacuum to the film-type pouch having the first side open, thermally fusing an opening part of the film-type pouch so that the graphite sheet is entirely sealed, and applying heat to a surface of the film-type pouch such that the thermal fusion layer is melt so that the graphite sheet and the surface of the film-type pouch are thermally fused with each other; and
a third process in which a border part of the graphite sheet is cut.

6. The manufacturing method of claim 5, wherein, in the second process, the vacuum-evacuation, the thermal fusion of the opening part, and the thermal fusion of the surface of the film-type pouch are performed simultaneously in a vacuum chamber by inputting the film-type pouch having the graphite sheet disposed in an inner portion of the film-type pouch in the vacuum chamber and depressurizing the film-type pouch under vacuum for a predetermined time and then pressing the film-type pouch with a vertical heating member.

7. The manufacturing method of claim 5, wherein the second process comprises a process in which the film-type pouch having the graphite sheet disposed in an inner portion of the film-type pouch is input in a vacuum chamber and is depressurized under vacuum for a predetermined time and then is heated and pressed so that the vacuum-evacuation is performed and the opening part is thermally fused, and comprises a process in which the film-type pouch is input in a high-temperature chamber and is heated so that the surface of the film-type pouch and the graphite sheet are thermally fused with each other.
